# EUROPÄISCHE PATENTANMELDUNG

(11) **EP 4 455 804 A1**
(43) Veröffentlichungstag der Anmeldung: **30.10.2024**
(21) Anmeldenummer: 23170742.3
(22) Anmeldetag: 28.04.2023
(51) Int. Cl.: G05B 17/02, G06F 30/17

(54) **COMPUTERGESTÜTZTES VERFAHREN SOWIE ANORDNUNG ZUR BILDUNG EINES DREIDIMENSIONALEN, KINEMATISCHEN MODELLS EINER ANLAGE, INSBESONDERE IM INDUSTRIELLEN UMFELD, ZUR BILDUNG EINES DIGITALEN ZWILLINGS DER ANLAGE**

(71) Anmelder: Siemens Aktiengesellschaft, 80333 München (DE)
(72) Erfinder: Baudisch, Thomas, 86938 Schondorf am Ammersee (DE)
(74) Vertreter: Siemens Patent Attorneys

(57) **Zusammenfassung**

Die Erfindung betrifft ein computergestütztes Verfahren sowie eine Anordnung zur Bildung eines dreidimensionalen, kinematischen Modells einer Anlage, insbesondere im industriellen Umfeld, zur Bildung eines Digitalen Zwillings der Anlage, bei dem ein
a) Erstellen und Speichern eines ersten 3D-Scans der Anlage zu einem ersten Zeitpunkt durch ein erstes Modul,
b) Erstellen und Speichern mindestens eines zweiten 3D-Scans der Anlage zu zumindest einem darauffolgenden zweiten Zeitpunkt in Abhängigkeit des Erfassungsergebnisses durch ein drittes Modul,
c) Erfassen von Mobilitätseigenschaften der Anlage durch ein zweites Modul,
d) Analysieren des ersten und/oder der zweiten 3D-Scans der Anlage zu, insbesondere gemäß CAD-Verfahren, gebildeten 3D-Geometrien je 3D-Scan durch ein viertes Modul,
e) Analysieren der 3D-Scans der Anlage in Abhängigkeit von zumindest des Aufnahmezeitpunkts zur Ermittlung von beweglichen und unbeweglichen 3D-Geometrien des jeweiligen Scans der Anlage durch das fünfte Modul,
f) Ermitteln von mindestens einer Eigenschaft der Bewegung je beweglicher 3D-Geometrie durch ein sechstes Modul,
g) Bestimmen der Art von Verbindungselementen, beispielsweise Gelenktyp, zwischen beweglichen und unbeweglichen 3D-Geometrien durch ein siebtes Modul,
h) Erzeugen des eines 3D-Modells anhand der erfassten 3D-Geometrien und der bestimmten Elemente und Zuführen zu einem achten Modul als Basis zur Bildung eines Digitalen Zwillings, erfolgt.

## Beschreibung

Die Erfindung betrifft ein computergestütztes Verfahren zur Bildung eines dreidimensionalen, kinematischen Modells einer Anlage, insbesondere im industriellen Umfeld, zur Bildung eines Digitalen Zwillings der Anlage, gemäß dem Oberbegriff des Anspruchs 1, sowie eine Anordnung zur Bildung eines dreidimensionalen, kinematischen Modells einer Anlage, insbesondere im industriellen Umfeld, zur Bildung eines Digitalen Zwillings der Anlage, gemäß dem Oberbegriff des Anspruchs 10.

Es ist bekannt parallel zu realen Objekten der physikalischen Welt, beispielsweise einer Anlage, insbesondere im industriellen Umfeld, einen Digitalen Zwilling zu betreiben.

Im industriellen Umfeld wird hierdurch beispielsweise der Einsatz in der Art eines so genannten "Industrial Metaverse" möglich. Ein solcher Einsatz erlaubt es virtuelle und erweiterte Realitäten in der industriellen Produktion und Wartung mit einzuschließen, so dass beispielsweise Prozesse optimiert oder die Effizienz in der Produktion gesteigert sowie Remote-Arbeiten und Schulungen unterstützt werden können.

Im Kontext des Industrial Metaverse ist dieser Digitale Zwilling ein realistisches 3D Modell der realen Anlage.

Die Erstellung von 3D-Modellen kann entweder durch manuelle Eingabe von Daten und/oder durch 3D-Scannen eines physischen Objekts erfolgen. Für die manuelle Eingabe von Daten werden normalerweise Tools eines computergestützten Designverfahrens, wie des so genannten "Computer Aided Design", CAD, oder ähnliche Software verwendet, die das digitale Modell des Objekts mit drei Dimensionen aufbaut, um es anschließend auf einem Computerbildschirm darzustellen.

Diese Erstellung von 3D-Modellen erfordert oft eine gründliche Kenntnis von Geometrie und Materialwissenschaften, um ein realistisches, funktionales Modell zu erstellen. Die Erstellung des 3D Modells kann einen enormen Aufwand bedeuten, insbesondere wenn die Erstellung manuell erfolgt, vor allem im Zusammenhang mit Bestandsanlagen, von denen es keine 3D CAD Daten oder andere Modelle gibt, die bei der Erstellung verwendet werden können.

Die der Erfindung zugrundeliegende Aufgabe ist es daher eine technische Lösung anzugeben, die die Nachteile des Standes der Technik überwindet, insbesondere ist es die Aufgabe der Erfindung eine technische Lösung anzugeben, die die Erstellung von 3D-Modellen von Anlagen, insbesondere im industriellen Umfeld, weitestgehend automatisiert.

Die Aufgabe wird durch das computergestützte Verfahren zur Bildung eines dreidimensionalen, kinematischen Modells einer Anlage, insbesondere im industriellen Umfeld, zur Bildung eines Digitalen Zwillings der Anlage, gemäß Oberbegriff des Anspruchs 1, durch dessen kennzeichnende Merkmale, sowie ausgehend von der Anordnung zur Bildung eines dreidimensionalen, kinematischen Modells einer Anlage, insbesondere im industriellen Umfeld, zur Bildung eines Digitalen Zwillings der Anlage, gemäß dem Oberbegriff des Anspruchs 10, durch dessen kennzeichnende Merkmale, gelöst.

Sofern es in der nachfolgenden Beschreibung nicht anders angegeben ist, beziehen sich die Begriffe "durchführen", "umsetzen", "transformieren", "übertragen", "berechnen", "rechnergestützt", "rechnen", "feststellen", "generieren", "konfigurieren", "rekonstruieren", "ermitteln", "erfassen" und dergleichen vorzugsweise auf Handlungen und/oder Prozesse und/oder Verarbeitungsschritte, die Daten verändern und/oder erzeugen und/oder die Daten in andere Daten überführen, wobei die Daten insbesondere als physikalische Größen dargestellt werden oder vorliegen können, beispielsweise als elektrische Impulse. Insbesondere sollte der Ausdruck "Computer" möglichst breit ausgelegt werden, um insbesondere alle elektronischen Geräte mit Datenverarbeitungseigenschaften abzudecken. Computer können somit beispielsweise Personal Computer, Server, speicherprogrammierbare Steuerungen (SPS), Handheld-Computer-Systeme, Pocket-PC-Geräte, Mobilfunkgeräte und andere Kommunikationsgeräte, die rechnergestützt Daten verarbeiten können, Prozessoren und andere elektronische Geräte zur Datenverarbeitung sein.

Unter "rechnergestützt" oder "computergestützt" kann im Zusammenhang mit der Erfindung beispielsweise eine Implementierung des Verfahrens verstanden werden, bei dem insbesondere ein Prozessor mindestens einen Verfahrensschritt des Verfahrens ausführt.

Unter einem Prozessor kann im Zusammenhang mit der Erfindung beispielsweise eine Maschine oder eine elektronische Schaltung verstanden werden. Bei einem Prozessor kann es sich insbesondere um einen Hauptprozessor (engl. Central Processing Unit, CPU), einen Mikroprozessor oder einen Mikrokontroller handeln. Bei einem Prozessor kann es sich beispielsweise auch um einen IC (integrierter Schaltkreis, engl. Integrated Circuit), insbesondere einen FPGA (engl. Field Programmable Gate Array) oder einen ASIC (anwendungsspezifische integrierte Schaltung, engl. Application-Specific Integrated Circuit), oder einen DSP (Digitaler Signalprozessor, engl. Digital Signal Processor) oder einen Grafikprozessor GPU (Graphic Processing Unit) handeln. Auch kann unter einem Prozessor ein virtualisierter Prozessor, eine virtuelle Maschine oder eine Soft-CPU verstanden werden. Es kann sich beispielsweise auch um einen programmierbaren Prozessor handeln, der mit Konfigurationsschritten zur Ausführung des genannten erfindungsgemäßen Verfahrens ausgerüstet wird oder mit Konfigurationsschritten derart konfiguriert ist, dass der programmierbare Prozessor die erfindungsgemäßen Merkmale des Verfahrens, der Komponente, der Module, oder anderer Aspekte und/oder Teilaspekte der Erfindung realisiert.

Unter einer "Speichereinheit" oder einem "Speichermodul" und dergleichen kann im Zusammenhang mit der Erfindung beispielsweise ein flüchtiger Speicher in Form von Arbeitsspeicher (engl. Random-Access Memory, RAM) oder ein dauerhafter Speicher wie eine Festplatte oder ein Datenträger sowie eine Kombination aus einer oder mehrerer dieser Elemente zur Bildung einer so genannten Cloud verstanden werden.

Unter einem "Modul" kann im Zusammenhang mit der Erfindung beispielsweise mindestens ein Prozessor und/oder mindestens eine Speichereinheit zum Speichern von Programmbefehlen verstanden werden, welche physisch an einem Ort, beispielsweise einem Teil einer Leiterplatte, funktional zusammenwirkend verbunden sind. Beispielsweise ist der Prozessor speziell dazu eingerichtet, die Programmbefehle derart auszuführen, damit der Prozessor Funktionen ausführt, um das erfindungsgemä-βe Verfahren oder einen Schritt des erfindungsgemäßen Verfahrens zu implementieren oder realisieren. Ein Prozessor beispielsweise kann auch mehrere der erfindungsgemäßen Funktionen oder Schritte des Verfahrens ausführen und somit ein- oder mehrere der gemäß Ansprüchen genannten realisieren.

Unter einem "Parameter", insbesondere eines digitalen Zwillings, kann insbesondere eine Einheit wie beispielsweise Physikalische Eigenschaft, Name, Größe, Farbe, Typ, Zustand, Parameter eines Einsatzortes usw., oder ein Merkmal, eine Charakteristik und/oder eine Konfiguration des computergestützten Simulationsmodells oder Produkts verstanden werden.

Unter einer "Anlage" kann insbesondere eine Maschine, wie z.B. eine Werkzeugmaschine oder ein Roboter, ein Gerät, wie z.B. ein Feldgerät, eine, insbesondere aus einem oder mehreren der vorstehend Genannten gebildete, industrielle Anlage, wie z.B. eine Produktionsanlage, verstanden werden.

Bei dem erfindungsgemäßen computergestützten Verfahren zur Bildung eines dreidimensionalen Modells einer Anlage, insbesondere im industriellen Umfeld, zur Bildung eines Digitalen Zwillings der Anlage, erfolgt ein
a) Erstellen und Speichern eines ersten 3D-Scans der Anlage zu einem ersten Zeitpunkt durch ein erstes Modul,
b) Erstellen und Speichern mindestens eines zweiten 3D-Scans der Anlage zu zumindest einem darauffolgenden zweiten Zeitpunkt in Abhängigkeit des Erfassungsergebnisses durch ein zweites Modul,
c) Erfassen von Mobilitätseigenschaften der Anlage durch ein drittes Modul,
d) Analysieren des ersten und/oder der zweiten 3D-Scans der Anlage zu, insbesondere gemäß CAD-Verfahren, gebildeten 3D-Geometrien je 3D-Scan durch ein viertes Modul,
e) Analysieren der 3D-Scans der Anlage in Abhängigkeit von zumindest des Aufnahmezeitpunkts zur Ermittlung von beweglichen und unbeweglichen 3D-Geometrien des jeweiligen Scans der Anlage durch das fünfte Modul,
f) Ermitteln von mindestens einer Eigenschaft der Bewegung je beweglicher 3D-Geometrie durch ein sechstes Modul,
g) Bestimmen der Art von Verbindungselementen, beispielsweise Gelenktyp, zwischen beweglichen und unbeweglichen 3D-Geometrien durch ein siebtes Modul,
h) Erzeugen des 3D-Modells anhand der erfassten 3D-Geometrien und der bestimmten Elemente und Zuführen zu einem achten Modul als Basis zur Bildung eines Digitalen Zwillings.

Durch das erfindungsgemäße computergestützte Verfahren wird eine technische Lösung angegeben, die es möglich macht für Anlagen weitestgehend automatisiert ein 3D-Modell zu erstellen. Dies wird nicht zuletzt durch die Kombination eines Zurückgreifens auf bekannte 3D-Geometrien als auch der Ableitung von Eigenschaften der Bewegung, sofern bewegliche Geometrien enthalten sind, was jedoch in der Regel der Fall sein wird, durch die Betrachtung der Aufnahmen über die Zeit erreicht, die die Bestimmung von Verbindungselementen und damit eines weitestgehend vollständig kinematisierten 3D-Modells ermöglicht, der für die Bildung des Digitalen Zwillings zugrunde gelegt werden kann.

Die erfindungsgemäße Anordnung zur Bildung eines dreidimensionalen Modells einer Anlage, insbesondere im industriellen Umfeld, zur Bildung eines Digitalen Zwillings ist gekennzeichnet durch Mittel zur Durchführung des computergestützten Verfahrens und/oder einer der Weiterbildungen des erfindungsgemäßen Verfahrens.

Die erfindungsgemäße Anordnung ermöglicht die Implementierung des erfindungsgemäßen Verfahrens und/oder seiner Weiterbildungen und damit mutatis mutandis auch die Realisierung der Vorteile des Verfahrens und/oder seiner Weiterbildungen.

Vorteilhafte Ausgestaltungen und Weiterbildungen der Erfindung sind durch die Unteransprüche angegeben.

Bei einer Weiterbildung des erfindungsgemäßen computergestützten Verfahrens werden abhängig davon, ob die Mobilitätseigenschaft derart ist, dass die Anlage zumindest ein bewegliches Element aufweist, zweite 3D-Scans zu so vielen zweiten Zeitpunkten derart erfasst und gespeichert, dass zu jedem beweglichen Element im Wesentlichen zu allen einnehmbaren Positionen ein 3D-Scan erfasst und gespeichert wird.

Dies hat neben dem Vorteil, dass auch verdeckte Teile der Anlage erfasst werden, so dass die 3D-Geometrien akkurat gebildet werden können, auch den Vorteil, dass mehrere Perspektiven für eine Analyse der Bewegung zur Verfügung stehen. Dies ist insbesondere bei der Ermittlung von Eigenschaften der Bewegung, insbesondere der Freiheitsgrade, vorteilhaft.

Wird das erfindungsgemäße computergestützte Verfahren derart weitergebildet, dass die zweiten Zeitpunkte derart fortgesetzt werden, dass eine kontinuierliche, insbesondere bei Visualisierung für einen Betrachter eine fließende Bewegung wiedergebende, Abfolge von 3D-Scans erfasst und gespeichert wird, wird eine streambare Bewegtbildabfolge erzeugt. Dies unterstützt insbesondere die Erstellung einer Ableitung von Bewegungseigenschaften bzw. die akkurate Erstellung eines Bewegungsprofils wird präziser.

Gemäß einer weiteren Ausgestaltung des erfindungsgemäßen computergestützten Verfahrens werden die zweiten Zeitpunkte derart fortgesetzt, dass eine, insbesondere bei Visualisierung für einen Betrachter, diskrete Orte, insbesondere zumindest Endlagen und/oder Wendepunkte eines bewegten Teils der Anlage, wiedergebende Abfolge von 3D-Scans erfasst und gespeichert wird.

Hierdurch wird das Maß der Präzision bei der Erstellung des Bewegungsprofils noch weiter verbessert, da sichergestellt ist, dass diese markanten Punkte maßgeblichen Einfluss auf die Bestimmung des Profils haben.

Vorzugsweise wird das erfindungsgemäße computergestützte Verfahren derart weitergebildet, dass durch ein achtes Modul aus zumindest einem Teil, insbesondere Start-, End- und/oder Wendepunkte, der gespeicherten 3D-Scans, jeweils eine sich durch den jeweiligen 3D-Scan ergebende Punktewolke beschreibende Daten erstellt und gespeichert werden.

Punktewolken sind besonders geeignet als Ergebnis eines Scans und können erfindungsgemäß auch direkt für die Erstellung und Analyse von 3D-Geometrien herangezogen zu werden. Das Erzeugen und Vorhalten der Daten erlaubt daher die effektive Durchführung der Schritte des erfindungsgemäßen computergestützten Verfahrens.

Dieser Vorteil kann verstärkt werden bzw. kommt ganz besonders zum Tragen, wenn das erfindungsgemäße computergestützte Verfahren derart weitergebildet wird, dass durch ein zehntes Modul auf Basis der Punktwolken beschreibenden Daten
a) ein Vergleich von, insbesondere in einer Datenbank, Cloudspeicher oder Ähnlichem, gespeicherten, durch festgelegte Punktwolkenformationen bestimmten 3D-Geometrien mit Punkten der jeweiligen sich ergebenden Punktwolke durchgeführt wird,
b) bei Übereinstimmung einer gespeicherten Geometrie eine Umwandlung des übereinstimmenden Teils der Punktewolke in die 3D-Geometrie erfolgt.

Wird das erfindungsgemäße computergestützte Verfahren derart weitergebildet, dass je bewegtes gespeichertes Geometrieelement eine digitale Bildfolge derart erzeugt wird, dass je 3D-Scan
a) auf Grundlage der 3D-Geometrien ein digitales Bild erstellt wird,
b) wobei eine feste mit der jeweiligen bewegten 3D-Geometrie verbundene gespeicherte 3D-Geometrie, als eine erste Abbildung innerhalb des digitalen Bildes erstellt wird, sowie die bewegte 3D-Geometrie als eine zweite Abbildung innerhalb des digitalen Bildes erstellt wird,
c) und wobei die Bildfolge derart erstellt wird, dass die zweite Abbildung in der jeweiligen sich durch den 3D-Scan ergebenden Punktwolke derart platziert wird, dass die bewegte 3D-Geometrie innerhalb der durch die sich ergebende Punktwolke gegebene Begrenzung je durch den 3D-Scan sich ergebende Punktwolke sukzessive nachgeführt wird,
d) die sich ergebende Bildfolge einem durch ein elftes Modul durchgeführten Bildverarbeitungsalgorithmus derart zugeführt wird, dass der Bildverarbeitungsalgorithmus eine Mustererkennung über die Bildfolge derart durchführt, dass ein Vergleich mit den Bewegungsmustern bekannter beweglicher Verbindungselemente, insbesondere Gelenke, erfolgt und bei Übereinstimmung die Art des Verbindungselements als erkannt und als Ausgangssignal derart ausgegeben wird, dass eine das Verbindungselement wiedergebende 3D-Geometrie festgelegt wird, wird eine Hüllkurve erzeugt, innerhalb der die zweite Abbildung in der Bildfolge mit Werkzeugen der Bildverarbeitung untersucht werden kann, so dass die hierdurch mögliche Bildanalyse Daten zur Bewegung liefern und somit ein ein Verbindungselement, insbesondere Gelenk, identifizierendes Muster abgeleitet werden kann. Hierdurch wird die automatische Erkennung von Verbindungselementen auf effektive Weise automatisiert.

Gemäß einer Weiterbildung des erfindungsgemäßen computergestützten Verfahrens werden auf Grundlage der 3D-Scans Parameter des Verbindungselements, insbesondere ein Bewegungsprofil definierende physikalische Größen, wie beispielsweise Geschwindigkeit und/oder Beschleunigung, und/oder geographische Größen wie Endlagen der Bewegung, abgeleitet. Mit diesen Daten kann das 3D-Modell bzw. der Digitale Zwilling entsprechend parametrisiert werden. Zudem fließen diese Daten in das Muster zur Erkennung des Verbindungselementes ein und führen zu einer zuverlässigeren Bestimmung des Verbindungselements.

Durch die Weiterbildung des erfindungsgemäßen computergestützten Verfahrens, derart, dass der digitale Zwilling unter Nutzung des 3D-Modells derart parametrisiert betreibbar ist, dass sein Zustand aufgrund zumindest einer Parametereingabe eine Änderung erfährt, die als Basis einer Anpassung im Betrieb und/oder Aufbau der Anlage nutzbar ausgegeben wird, werden die Wirkungen des computergestützten Verfahrens auf die physikalische Umgebung durch die hierdurch mögliche Implementierung von Anpassungen und/oder Verbesserungen in der Anlage realisiert.

Weitere Vorteile und Details der Erfindung werden anhand der in den Figuren 1 bis 6 dargestellten Ausführungsbeispiele der Erfindung erläutert. Dabei zeigt
- FIGUR 1: schematisch ein Ablaufdiagramm eines Ausführungsbeispiels des erfindungsgemäßen computergestützten Verfahrens,
- FIGUR 2: schematisch Grundlagen der erfindungsgemäßen Bildanalyse von bewegten Objekten,
- FIGUR 3: schematisch eine Auswahl an Gelenktypen, die dem Ausführungsbeispiel des erfindungsgemäßen computergestützten Verfahrens zugrunde gelegt sind.

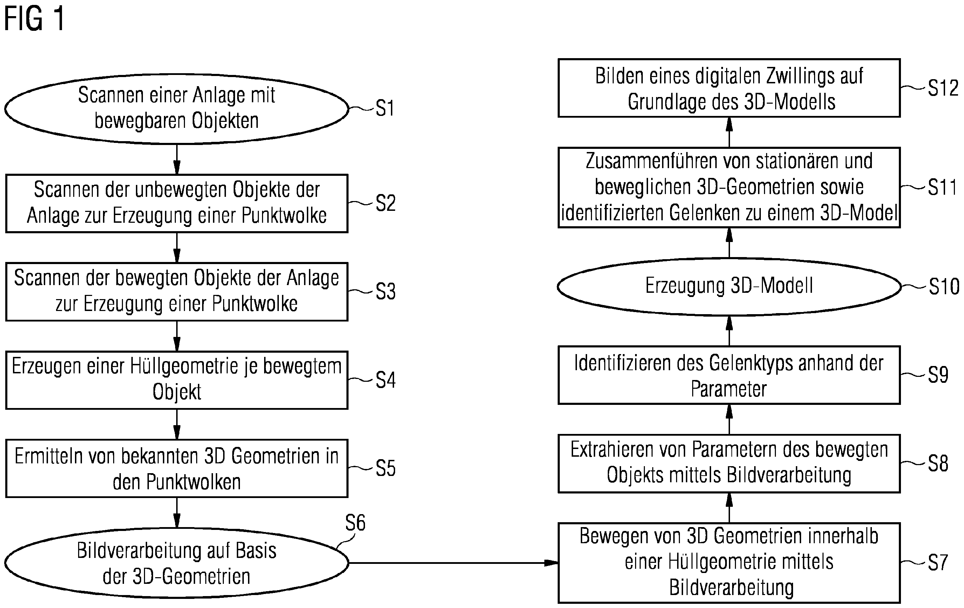

Bei den im Folgenden in FIGUR 1 bis FIGUR 3 erläuterten Ausführungsbeispielen handelt es sich um bevorzugte Ausführungsformen und Weiterbildungen der Erfindung.

Bei den Ausführungsbeispielen stellen die beschriebenen Komponenten der Ausführungsformen jeweils einzelne, unabhängig voneinander zu betrachtende Merkmale der Erfindung dar, welche die Erfindung jeweils auch unabhängig voneinander weiterbilden und damit auch einzeln oder in einer anderen als der gezeigten Kombination als Bestandteil der Erfindung anzusehen sind.

Des Weiteren sind die beschriebenen Ausführungsformen auch durch weitere der bereits beschriebenen Merkmale der Erfindung ergänzbar.

Gleiche Bezugszeichen haben in den verschiedenen Figuren die gleiche Bedeutung.

Figur 1 zeigt schematisch ein Ablaufdiagramm eines Ausführungsbeispiels des computergestützten Verfahrens zur Bildung eines dreidimensionalen Modells einer Anlage, insbesondere im industriellen Umfeld, zur Bildung eines Digitalen Zwillings der Anlage.

Zu erkennen ist, dass das Verfahren in einem ersten Schritt S1 sich in einem Zustand "Scannen einer Anlage mit bewegbaren Objekten" beginnt.

Das Scannen kann dabei mit bekannten Anordnungen, wie stationären und/oder mobilen 3D-Scannern durchgeführt werden. In der Regel werden Präzisionsgeräte die notwendige Genauigkeit, insbesondere im industriellen Umfeld, bereitstellen. Denkbar ist aber auch die Nutzung von mit 3D-Scannerfunktion erweiterten Endgeräten, wie beispielsweise Handys, Tablet und/oder Kameras mit entsprechender Software, die für eine akkurate Erfassung sorgt.

Ausgehend von diesem Zustand wird mit dem 3D-Scanner in einem zweiten Schritt S2 die Anlage derart gescannt, dass die unbeweglichen Objekte erfasst werden. Dies wird in der Regel durch einen bis einige wenige Scanvorgänge umgesetzt werden können, da die Position dieser Objekte sich nicht ändert und daher etwaige über einen Scanvorgang hinausgehende Scanvorgänge beispielsweise lediglich der Erfassung verdeckter Teile der Anlage dienen.

Auf Grundlage des zweiten Schrittes S2 wird dann für die folgenden erfindungsgemäßen Schritte eine die - zumindest zum Zeitpunkt der Aufnahme - stationären Objekte der Anlage wiedergebende Punktewolke ermittelt und, beispielsweise in einer lokalen oder insbesondere Cloud ausgelagerten Speichervorrichtung vorgehalten.

In einem dritten Schritt S3, der zeitlich vor dem oder nach dem zweiten Schritt S2 oder sogar zumindest zeitweise gleichzeitig während des Durchführens des zweiten Schrittes S2 erfolgen kann, werden die beweglichen Objekte der Anlage gescannt.

Hierzu werden für alle beweglichen Objekte Scanvorgänge derart durchgeführt, dass jedes bewegte Objekt der Anlage derart angesteuert wird, dass es in alle Positionen bewegt wird, die es einnehmen kann. Das wird in der Regel eine Bewegung sein, die von einem Startpunkt und je nach Freiheitsgraden über etwaige Wende-/Zwischenpunkte zu mindestens einem Endpunkt erfolgt, wobei das Ansteuern all dieser Punkte erfindungsgemäß gescannt wird. Beispielsweise kann eine Ausgestaltung der Erfindung derart erfolgen, dass einfach alle Bewegungen, die eine Anlage, beispielsweise einer Montagestation, gemäß einer, wie dem so genannten "Programmable Logic Controller" (programmierbare logische Einheit) implementierten und ausgeführten, Steuerung ohnehin im Rahmen seiner Funktion in der Anlage ausführt, gescannt werden.

Teilweise gleichzeitig und/oder nachgelagert zu dem dritten Schritt S3 wird in einem vierten Schritt S4 dabei je Objekt aus den angefahrenen Start-, Zwischen- und Endpunkten eine durch die äußeren Ränder des jeweiligen Objektes gebildete Punktwolke ermittelt, die eine Hüllgeometrie darstellt. Diese Hüllkurve bzw. die Punktwolke wird ebenfalls für die weiteren Schritte gemäß dem erfindungsgemäßen Verfahren vorgehalten.

In einem fünften Schritt S5 gemäß Ausführungsbeispiel des erfindungsgemäßen Verfahrens erfolgt ein Ermitteln von 3D-Geometrien in den von der Anlage erzeugten Punktwolken. Dabei kann dies beispielsweise auf Grundlage von aus dem so genannten "Computer Aided Design", CAD, bekannten 3D-Geometrien handeln, aus denen man mittels eines CAD Tools 3D-Modelle generieren kann. Diese 3D-Geometrien werden hierzu dem erfindungsgemäßen Verfahren, beispielsweise in einer als, insbesondere Datenbank mit strukturiert hinterlegten 3D-Geometrien, lokal und/oder über ein Netzwerk abrufbar, ausgestalteten Speichereinrichtung verfügbar gemacht, so dass durch die verfügbaren 3D-Geometrien unter Nutzung der Punktewolken die Objekte der Anlage weitestgehend durch die verfügbaren 3D-Geometrien gebildet zusammengesetzt werden können.

In einem weiteren, dem sechsten, Schritt S6 geht das erfindungsgemäße Verfahren nun in einen Bildverarbeitungsmodus, in dem in einem siebten Schritt S7 nun erfindungsgemäß die Nutzung der Hüllkurven und der ermittelten 3D-Geometrien, welche die bewegten Objekte der Anlage darstellen, derart erfolgt, dass je bewegtes Objekt einzelne Bilder erzeugt werden, in denen die das bewegte Objekt repräsentierenden 3D-Geometrien innerhalb der Hüllkurve von Bild zu Bild sukzessive von Start- über etwaige Zwischen-/Wendepunkte hin zu dem/den Endpunkt/-en verschoben, dargestellt werden, so dass eine die Bewegung wiedergebende Bildsequenz entsteht.

Mittels gängigen Bildverarbeitungswerkzeugen werden erfindungsgemäß nun aus den einzelnen Bildern und/oder der Bildsequenz Informationen extrahiert, die für die Bildung eines 3D-Modells, welches zumindest als Grundlage eines Digitalen Zwillings der Anlage dienen soll, genutzt werden.

Diese Informationen werden als Parameter in einem achten Schritt S8 extrahiert, wobei die Parameter zumindest eine oder mehrere der folgenden Informationen sein können:
- Der Typ der Bewegung, also beispielsweise transversale Bewegung, eine Drehbewegung oder eine Kombination davon, kann als einer der Parameter abgeleitet werden und auf eine Gelenkart hindeuten.
- Die Position eines Gelenks kann als einer der Parameter abgeleitet werden.
- Endlagen der Bewegung können als einer der Parameter ermittelt werden.
- Ein Bewegungsprofil kann abgeleitet werden, dieses kann beispielsweise durch die Geschwindigkeit oder Beschleunigung, die als ein Parameter abgeleitet werden können, bestimmt sein.

Anhand einem oder mehrerer der genannten Parameter kann dann in einem neunten Schritt S9 der Typ des Gelenks bestimmt werden, der das bewegte Objekt mit dem unbewegten Objekt in der Anlage verbindet.

Ist der Gelenktyp bestimmt, kann das erfindungsgemäße Verfahren in den Zustand "Erzeugung 3D-Modell" übergehen.

In diesem Zustand wird unter anderem die durch die Erfindung im Wesentlichen mittels Bildverarbeitung automatisch ermittelte Information nutzend dann in einem elften Schritt S11 je bewegtem Objekt in den Punktwolken ein Zusammenführen von bewegten und unbewegten 3D-Geometrien über ein Modell des Gelenks erfolgen, so dass damit jeweils ein 3D-Modell der einzelnen bewegten Objekte der Anlage und somit ein 3D-Modell der gesamten Anlage erzeugt und der Bildung eines (3D) Digitalen Zwillings in einem zwölften und letzten Schritt S12 zugeführt werden kann und mit dem Digitalen Zwilling virtuelle Zustandsänderungen herbeigeführt werden können, die letztlich zu Änderungen/Anpassungen in der realen Anlage führen.

Mit dem erfindungsgemäßen Verfahren wird also ein manueller, zeitaufwändiger Prozess vermieden, der ohne die Erfindung für die Erstellung des 3D Digitalen Zwillings notwendig wäre.

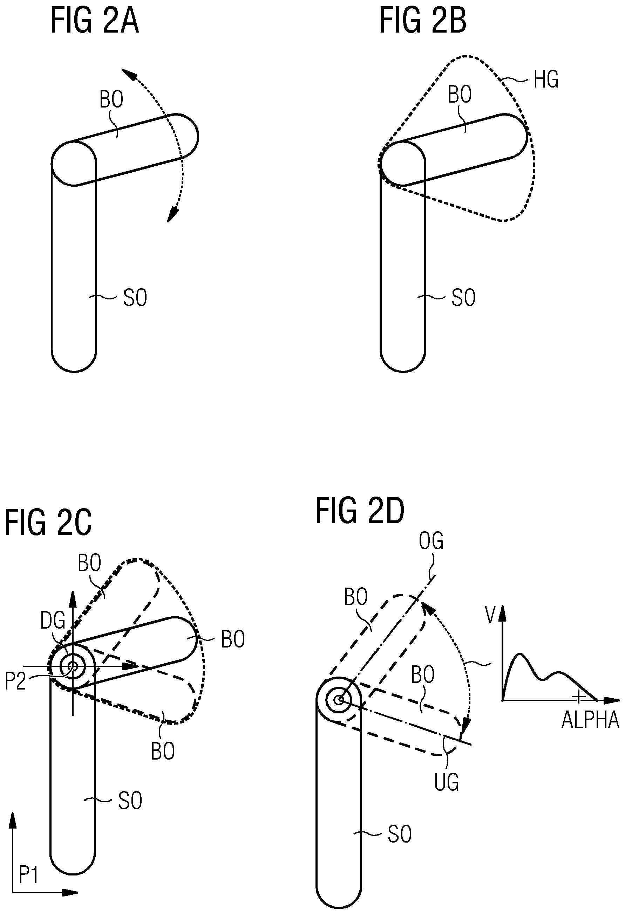

In der Figur 2 bzw. den Teilfiguren 2a bis 2d sollen einzelne der in der vorhergehenden Figur erläuterten Schritte etwas detaillierter betrachtet werden.

Figur 2a zeigt einen Teil der Anlage bestehend aus einem bewegten Objekt BO und einem unbeweglichen, stationären Objekt SO, wie sie beispielsweise im ersten Schritt S1 und zweiten Schritt S2 gescannt wurden und - nicht dargestellt - als Punktwolke hinterlegt wurden.

Wenn man nun dem dritten Schritt S3 gemäß das bewegte Objekt BO alle Positionen einnehmen lässt, dann wird, wie im vierten Schritt S4 erläutert die Hüllgeometrie HG erzeugt, welche sich durch die äußeren Ränder des bewegten Objekts BO ergibt. Die die Hüllgeometrie HG darstellende Punktwolke, die dabei generiert wird, ist in Figur 2b schematisch gepunktet angedeutet.

In den folgenden Teilfiguren 2c und 2d sind nun beispielhaft Teile der mittels Bildverarbeitung ermittelbaren Parameter gezeigt.

In der Teilfigur 2c ist schematisch dargestellt wie die Bildverarbeitung Parameter wie die Position P1 des stationären Objektes SO, den Typ des Gelenks, im vorliegenden Beispiel ein Drehgelenk DG, sowie die Position P2 des Gelenks DG ermittelt. Bei dem Bewegen des bewegten Objekts an die einnehmbaren Positionen ergibt die Bildverarbeitung, d.h. die Analyse der Bildfolgen, dass eine Drehbewegung um einen Fixpunkt geschieht. Aus der Lage des Fixpunktes ist die Position P2 des Drehgelenks ableitbar und die Bewegungsart, Drehung um den Fixpunkt sowie der Umriss der Hüllkurve, führt zur Bestimmung des Gelenks als Drehgelenk DG.

Durch Einnehmen der Positionen durch das bewegliche Objekt BO lässt sich auch, wie in der letzten Teilfigur 2d schematisch dargestellt, die Geschwindigkeit V und Beschleunigung ALPHA des beweglichen Objekts BO aus der Bewegtbildfolge und der bekannten Größe Zeit, die bei der Bewegung von der Untergrenze UG hin zu einer Obergrenze vergangen ist, ermitteln.

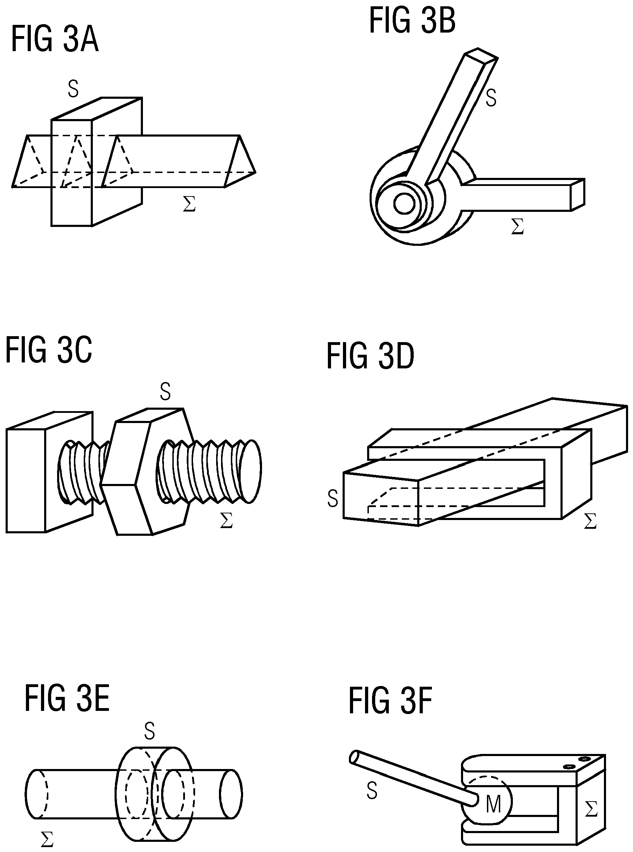

Figur 3 zeigt bzw. die Teilfiguren 3a bis 3f zeigen bekannte Typen von Gelenken. Diese bekannten Typen werden bei der erfindungsgemäßen Erkennung herangezogen. Es handelt sich bei
- Figur 3a: um ein Schubgelenk mit dem Freiheitsgrad f = 1,
- Figur 3b: um ein Drehgelenk mit dem Freiheitsgrad f = 1,
- Figur 3c: um ein Schraubgelenk, welches auf einer Schraubenlinie schiebbar ist, also den Freiheitsgrad f = 1 aufweist.
- Figur 3d: um ein Plattengelenk, bei dem ein Schieber in einer Ebene schieb- und senkrecht dazu drehbar gelagert ist, also den Freiheitsgrad f = 3 aufweist,
- Figur 3e: um ein Drehschubgelenk, das axial schieb- und um eine Achse drehbar ist und somit einen Freiheitsgrad f = 2 aufweist,
- Figur 3f: um ein Kugelgelenk, bei dem eine Kugel zwischen zwei im äußeren Teil sich gegenüber befindenden Pfannen geführt wird, so dass ein Freiheitsgrad von f = 3 gegeben ist.

Diese Aufzählung ist nicht abschließend, sondern hier sind nur beispielhaft die gängigsten Gelenke gezeigt. Es gibt weitere Gelenke, die ebenfalls umfasst sind, wie beispielsweise das nicht dargestellte und erfindungsgemäß wie alle weiteren nicht dargestellten Gelenktypen als Grundlage der erfindungsgemäßen Erkennung genutzte Kurvengelenk.

Anhand der dargestellten Gelenke lässt sich die Erkennung des Gelenktyps etwas detaillierter an einem vom oben erkannten Drehgelenk DG abweichenden Beispiel eines Gelenks nachvollziehen.

Beispielsweise würde bei einem Schubgelenk wie dem in Figur 3a gezeigten die vorstehend beschriebene Bildanalyse gemäß Bildverarbeitung ein Verschieben zwischen zwei Endpunkten innerhalb einer rechteckigen Hüllkurve zeigen.

Es ergäbe sich also ein Freiheitsgrad von f=1. Die rechteckige Hüllkurve, der Freiheitsgrad, die Lage des bewegten Objekts und des stationären Objekts zueinander während der Durchführung der Bewegung würde die anderen Gelenktypen ausschließen bzw. das Schubgelenk zwingend identifizieren.

Würde es sich um ein Kugelgelenk handeln, so gäbe es zwar einen Fixpunkt, aber die Analyse der Bewegung würde im Unterschied zu dem Drehgelenk die Bewegung um mehrere Achsen offenbaren, Fixpunkt und die Freiheitsgrade würden somit das Kugelgelenk als Gelenktyp festlegen.

An diesem Beispiel zeigt sich auch der Vorteil einer Aufnahme der Anlage bzw. seiner bewegten Teile aus mehreren Perspektiven, die gemäß Weiterbildung der Erfindung vorgesehen ist und insbesondere vorteilhaft das Erkennen von Gelenken mit mehreren Freiheitsgraden unterstützt.

In anderen Worten wird mit den gezeigten Ausführungsbeispielen der Erfindung wie erläutert also eine automatische Erzeugung eines kinematisierten 3D (Simulations)Modells bestehend aus CAD Körpern und Gelenken bewirkt.

Durch die Erfindung wird es dadurch möglich für die Erzeugung eines 3D Modells für die Fälle, in denen 3D Modelle der Anlagenkomponenten nicht bekannt sind, diese mittels CAD und 3D Scanner hinzuzufügen oder sogar komplett zu erzeugen.

Damit sich das 3D Modell genauso wie die reale Anlage bewegt, ermöglicht die Erfindung dabei, dass die, nach dem Scannen erkannten, beispielsweise CAD-, Komponenten kinematisiert werden, indem einzelne 3D-Geometrien Gelenke automatisch erkannt und gewissermaßen eingebaut werden.

Durch die Erfindung entfallen also manuelle Vorgänge wie die Beschreibung der Bewegung, um ein Modell zu erzeugen. Es entfällt also Endlagen anzugeben und ein Verfahrprofil zwischen den Endlagen zu programmieren. Die Erfindung ist auch vorteilhafter gegenüber anderen Alternativen, die automatisiertes Vorgehen erlauben, wie beispielsweise das Beschaffen der Verfahrinformation über eine Verbindung zu einer externen Steuerung.

Die Erfindung ist nicht auf die beschriebenen Ausgestaltungen und Weiterbildungen beschränkt. Vielmehr sind alle unter den Schutzbereich der Ansprüche fallenden Weiterbildungen und Kombinationen von einzelnen, mehreren oder allen anspruchsgemäßen Merkmalen gemäß den Ansprüchen umfasst.

Soweit oben Ausdrücke verwendet wurden, die ein grammatikalisches Geschlecht und/oder andere zur Unterscheidung von Menschen geeignete Merkmale zeigen, implizieren oder als solche wahrgenommen werden können, gilt, dass diese Ausdrücke nicht trennend, sondern inklusiv verwendet wurden, d.h. dass alle Menschen - unabhängig von gegebenen, selbst angenommenen oder vermuteten individuellen Merkmalen - als gleichwertig betrachtet werden.

## Patentansprüche

1. Computergestütztes Verfahren zur Bildung eines dreidimensionalen, kinematischen Modells einer Anlage, insbesondere im industriellen Umfeld, zur Bildung eines Digitalen Zwillings der Anlage,
**dadurch gekennzeichnet, dass** ein
a) Erstellen und Speichern eines ersten 3D-Scans der Anlage zu einem ersten Zeitpunkt durch ein erstes Modul,
b) Erstellen und Speichern mindestens eines zweiten 3D-Scans der Anlage zu zumindest einem darauffolgenden zweiten Zeitpunkt in Abhängigkeit des Erfassungsergebnisses durch ein zweites Modul,
c) Erfassen von Mobilitätseigenschaften der Anlage durch ein drittes Modul,
d) Analysieren des ersten und/oder der zweiten 3D-Scans der Anlage zu, insbesondere gemäß CAD-Verfahren, gebildeten 3D-Geometrien je 3D-Scan durch ein viertes Modul,
e) Analysieren der 3D-Scans der Anlage in Abhängigkeit von zumindest des Aufnahmezeitpunkts zur Ermittlung von beweglichen und unbeweglichen 3D-Geometrien des jeweiligen Scans der Anlage durch das fünfte Modul,
f) Ermitteln von mindestens einer Eigenschaft der Bewegung je beweglicher 3D-Geometrie durch ein sechstes Modul,
g) Bestimmen der Art von Verbindungselementen, beispielsweise Gelenktyp, zwischen beweglichen und unbeweglichen 3D-Geometrien durch ein siebtes Modul,
h) Erzeugen des dreidimensionalen Modells anhand der erfassten 3D-Geometrien und der bestimmten Elemente und Zuführen zu einem achten Modul als Basis zur Bildung eines Digitalen Zwillings, erfolgt.

2. Computergestütztes Verfahren nach dem vorhergehenden Anspruch,
**dadurch gekennzeichnet, dass** abhängig davon, ob die Mobilitätseigenschaft derart ist, dass die Anlage zumindest ein bewegliches Element aufweist, zweite 3D-Scans zu so vielen zweiten Zeitpunkten derart erfasst und gespeichert werden, dass zu jedem beweglichen Element im Wesentlichen zu allen einnehmbaren Positionen ein 3D-Scan erfasst und gespeichert wird.

3. Computergestütztes Verfahren nach dem vorhergehenden Anspruch,
**dadurch gekennzeichnet, dass** die zweiten Zeitpunkte derart fortgesetzt werden, dass eine kontinuierliche, insbesondere bei Visualisierung für einen Betrachter eine fließende Bewegung wiedergebende, Abfolge von 3D-Scans erfasst und gespeichert wird.

4. Computergestütztes Verfahren nach einem der beiden vorhergehenden Ansprüche,
**dadurch gekennzeichnet, dass** die zweiten Zeitpunkte derart fortgesetzt werden, dass eine, insbesondere bei Visualisierung für einen Betrachter, diskrete Orte, insbesondere zumindest Endlagen und/oder Wendepunkte eines bewegten Teils der Anlage, wiedergebende Abfolge von 3D-Scans erfasst und gespeichert wird.

5. Computergestütztes Verfahren nach einem der beiden vorhergehenden Ansprüche,
**dadurch gekennzeichnet, dass** durch ein achtes Modul aus zumindest einem Teil, insbesondere Start-, End- und/oder Wendepunkte, der gespeicherten 3D-Scans, jeweils eine sich durch den jeweiligen 3D-Scan ergebende Punktewolke beschreibende Daten erstellt und gespeichert werden.

6. Computergestütztes Verfahren nach dem vorhergehenden Anspruch,
**dadurch gekennzeichnet, dass** durch ein zehntes Modul auf Basis der Punktwolken beschreibenden Daten
a) ein Vergleich von, insbesondere in einer Datenbank, Cloudspeicher oder Ähnlichem, gespeicherten durch festgelegte Punktwolkenformationen bestimmten 3D-Geometrien mit Punkten der jeweiligen sich ergebenden Punktwolke durchgeführt wird,
b) bei Übereinstimmung einer gespeicherten Geometrie eine Umwandlung des übereinstimmenden Teils der Punktwolke in die 3D-Geometrie erfolgt.

7. Computergestütztes Verfahren nach dem vorhergehenden Anspruch,
**dadurch gekennzeichnet, dass** je bewegtem gespeichertem Geometrieelement eine digitale Bildfolge derart erzeugt wird, dass je 3D-Scan
a) auf Grundlage der 3D-Geometrien ein digitales Bild erstellt wird,
b) wobei eine feste, mit der jeweiligen bewegten 3D-Geometrie verbundene gespeicherte 3D-Geometrie, als eine erste Abbildung innerhalb des digitalen Bildes erstellt wird, sowie die bewegte 3D-Geometrie als eine zweite Abbildung innerhalb des digitalen Bildes erstellt wird,
c) und wobei die Bildfolge derart erstellt wird, dass die zweite Abbildung in der jeweiligen sich durch den 3D-Scan ergebenden Punktwolke derart platziert wird, dass die bewegte 3D-Geometrie innerhalb der durch die sich ergebende Punktwolke gegebene Begrenzung je durch den 3D-Scan sich ergebende Punktwolke sukzessive nachgeführt wird,
d) die sich ergebende Bildfolge einem durch ein elftes Modul durchgeführten Bildverarbeitungsalgorithmus derart zugeführt wird, dass der Bildverarbeitungsalgorithmus eine Mustererkennung über die Bildfolge derart durchführt, dass ein Vergleich mit den Bewegungsmustern bekannter beweglicher Verbindungselemente, insbesondere Gelenke, erfolgt und bei Übereinstimmung die Art des Verbindungselements als erkannt und als Ausgangssignal derart ausgegeben wird, dass eine das Verbindungselement wiedergebende 3D-Geometrie festgelegt wird.

8. Computergestütztes Verfahren nach einem der vorhergehenden Verfahren,
**dadurch gekennzeichnet, dass** auf Grundlage der 3D-Scans Parameter des Verbindungselements, insbesondere ein Bewegungsprofil definierende physikalische Größen, wie beispielsweise Geschwindigkeit und/oder Beschleunigung, und/oder geographische Größen wie Endlagen der Bewegung, abgeleitet werden.

9. Computergestütztes Verfahren, nach einem der vorhergehenden Ansprüche,
**dadurch gekennzeichnet, dass** der digitale Zwilling unter Nutzung des 3D-Modells derart parametrisiert betreibbar ist, dass sein Zustand aufgrund zumindest einer Parametereingabe eine Änderung erfährt, die als Basis einer Anpassung im Betrieb und/oder Aufbau der Anlage nutzbar ausgegeben wird.

10. Anordnung zur Bildung eines dreidimensionalen Modells einer Anlage, insbesondere im industriellen Umfeld, zur Bildung eines Digitalen Zwillings, **gekennzeichnet durch** Mittel zur Durchführung des computergestützten Verfahrens nach einem der vorhergehenden Ansprüche.
